# EUROPEAN PATENT SPECIFICATION

(11) **EP 2 243 855 B1**
(45) Date of publication and mention of the grant of the patent: **03.03.2021**
(21) Application number: 09158528.1
(22) Date of filing: 22.04.2009
(51) Int. Cl.: B23K 26/08, B23K 26/06, C23C 14/28, C23C 14/04

(54) **Pulsed laser deposition with exchangeable shadow masks**
Gepulstes Laserstrahlverdampfen mit austauschbaren Lochmasken
Dépôt laser à impulsion avec des masques perforés échangeables

(43) Date of publication of application: 27.10.2010
(73) Proprietor: Solmates B.V., 7521 PE Enschede (NL)
(72) Inventor: Broekmaat, Joska Johannes, 7511 DS, Enschede (NL); Dekkers, Jan Mathijn, 7611 AN, Aadorp (NL); Janssens, Jan Arnoud, 7412 DL, Deventer (NL)
(74) Representative: 't Jong, Bastiaan Jacob

(56) References cited:
- WO-A-98/47613
- WO-A-2007/118463
- FR-A- 2 513 661
- US-A- 3 117 025
- US-A- 4 492 180

## Description

The application relates to a device for pulsed laser deposition, which device comprises:
- a substrate mount with a substrate mounted thereon;
- a target mount with a target material mounted thereon and opposite of the substrate mount;
- a laser device for directing a laser beam on the target material; and
- a shadow mask arranged over the substrate.

Pulsed laser deposition (PLD) is a known technique for arranging a coating on an object. With this technique material of a target material is ablated by a laser, such that a plasma plume of this target material is achieved. This plasma plume then is deposited on a substrate resulting in a coating of the target material on the substrate.

PLD was at first developed for coating small substrate surfaces, typically 10 millimeters by 10 millimeters. This is typically used in research environments, where small substrates are coated with all kinds of materials with high thin film quality.

Resulting from this research a need to coat larger surfaces originated. This has resulted in innovative techniques with which surfaces having a typical diameter of several inches or more can be coated As an example of existing installations , US-A-4492180 discloses substrate mount, a target mount, an evaporation device (not PLD) for the target and a shadow mask arranged over the substrate comprising a disk movable in axial direction to and from the substrate mount.

The substrate can be coated with several layers with this PLD technique. Out of such a substrate with several layers, it is possible to manufacture devices by applying photolithography. The disadvantage of this manufacturing process, is that the substrate has to be removed from the vacuum chamber and has to be transported to a clean room for the photolithography. The process photolithography is often used in microfabrication to selectively remove parts of a thin film (or the bulk of a substrate). It is used to transfer a geometric pattern from a photomask to a light-sensitive chemical (photoresist, or simply "resist") on the substrate. A series of chemical and/or physical treatments then engraves the exposure pattern into the material underneath the photoresist. In a complex integrated circuit (for example, modern CMOS), a wafer will go through the photolithographic cycle up to 50 times.

Sometimes it is necessary to transport the substrate back to the vacuum chamber to arrange by PLD an additional coating. Due to the risk of contamination by dust particles of the substrate, this method is undesired. Another disadvantage is that the substrate with thin films and structure has often to be heated again for the deposition process. Heating after cooling can have an influence on the deposited thin film properties and has to be limited as well. Another method to structure a pattern during deposition is to place a shadow mask or stencil on top of the substrate with a small mask-substrate distance. This configuration ensures that a specific pattern is coated on the substrate by PLD. Such a shadow mask is attached to the substrate by screws or bolts and is typically mounted on as well as removed from the substrate outside of the vacuum chamber. It is necessary to arrange the shadow mask in close contact with the substrate to achieve a sharp image of the mask onto the substrate.

This kind of attachment is furthermore necessary as the prior art PLD techniques have the substrate mount arranged vertically. Without a proper attachment of the shadow mask to the substrate, the mask could shift or even come loose from the substrate.

Accordingly it is an object of the invention to at least partially resolve the above mentioned problems.

This object is achieved by the invention, which is characterized in that the shadow mask is arranged in a movable disc, which movable disc is movable in axial direction to and from the substrate mount and that the shadow mask is in abutment with the substrate, as well as the presence of spring means for urging the mask against the movable disc.

With a device according to the invention it is possible to arrange and remove the shadow mask when desired. This is done by moving the movable disc away from the substrate mount, such that the disc is free to move in directions parallel to the substrate surface. Then the disc is moved to a desired position, for example to a position in which the shadow mask is positioned over the substrate mount. Finally, the disc is again lowered onto the substrate mount, such that an abutment is established between the substrate on the substrate mount and the shadow mask arranged in the movable disc.

The movement of the disc could be a rotation, translation or combination of both in one or more dimensions. Preferably, the disc can be translated in axial direction and rotated around the axis.

Preferably the movable disc comprises a number of shadow masks. This enables the manufacturing of devices with the PLD technique having complex structures.

In an embodiment of the device according to the invention the movable disc comprises at least one opening for housing the shadow mask. Preferably, the opening comprises a flange for supporting the shadow mask.

In this embodiment, the shadow mask is housed in the opening, which ensures a correct position of the shadow mask relative to the movable disc. Additionnally the invention comprises spring means for urging the at least one shadow mask against the movable disc. As the shadow mask is spring mounted, small differences in alignment in the direction perpendicular to the surface of the substrate can be resolved. Furthermore, the spring means provide a substantial constant force with which the shadow mask is pressed against the substrate.

For large area PLD the substrate is sometimes rotated. If the substrate rotates the shadow mask has to rotate as well. To ensure that the gap between the rotating mask and substrate is small a relatively heavy ring can be placed on top of the shadow mask such that additional force can be exploited. This ring is placed such that no holes of the shadow mask are covered. The ring can have a complex structure such that also the middle part of the shadow mask can be pushed against the substrate.

In another preferred embodiment of the device according to the invention the at least one shadow mask comprises primary alignment means for aligning the shadow mask relative to the movable disc. These alignment means could for example comprise a ridge arranged on the shadow mask, which co acts with a notch in the movable disc.

In yet another preferred embodiment of the device according to the invention, the device comprises secondary alignment means for aligning the movable disc to the substrate mount. The disc could for example be under an angle, such that the shadow mask is not properly brought into contact with the substrate. Also due to eccentricity of the disc, it could be that not all shadow masks would be aligned the same without the secondary alignment means.

Preferably, at least two alignment notches are arranged on opposite sides of the substrate mount for aligning cooperation with the movable disc. For example pins arranged on the disc or the shadow mask could be inserted into these alignment notches.

In a very preferred embodiment of the device according to the invention the target mount is arranged on a movable arm comprising a number of target mounts. This enables one to deposit several materials on the substrate without having to open up the vacuum chamber to exchange the target material. In combination with the exchangeable shadow masks it is possible to manufacture complex devices composed out of several layers of different materials and in different patterns.

Yet another embodiment of the invention comprises vision means for observing the orientation of the at least one shadow mask relative to the substrate. Preferably the vision means comprise a camera or a microscope.

With the invention several masks can be easily exchanged but the masks still have to be aligned with respect to the substrate structures. Aligning several masks relative to the substrate with a micrometer precession can be done according to the invention with positioners and vision means such as an optical or scanning electron microscope. With such a microscope the in plane movement (x, y) as well as the rotation (ϕ) of the substrate relative to the mask can be observed during manipulation. The substrate which is placed on a holder should be positionable in x, y, z as well as rotated. The microscope observation can be used as feedback in the positioning of the substrate relative to the mask.

When the vision means cannot observe the shadow mask in one view or when a close-up is desired, it is preferred that the vision means can be moved in at least two dimensions parallel to the shadow mask. Movement in the third dimension can be used for focusing the vision means and / or for removing the vision means.

In another embodiment the vision means are movable towards and away from the at least one shadow mask. Preferably, the the vision means are arranged on the rotatable arm. However, the vision means can also be arranged on a separate guide attached to the vacuum chamber wall or the like.

In order to look at the surface and position the substrate relative to the shadow mask an optical microscope preferably has to be placed directly above the shadow mask to observe the alignment markers which are typically used in photolithography to align sequentially several masks.

The inventions furthermore relates to a method for operating a device according to the invention, the method comprising the steps of:
- arranging a first shadow mask over the substrate and lowering the movable disc, such that the shadow mask is in abutment with the substrate;
- radiating the target material with the laser beam, such that a coating of target material is arranged on the substrate in accordance with the first shadow mask;

- moving the movable disc up and rotating the disc, such that a second shadow mask is arranged over the substrate; and
- repeating the steps.

In a further embodiment of the method according to the invention, the rotatable arm is rotated such that a second target mount with a second target material is arranged opposite of the substrate.

Preferably, the method according to the invention comprises the step of moving the substrate mount up after lowering the movable disc. This makes it possible to properly align the movable disc to the substrate mount and by moving the substrate mount up, it is ensured that the substrate is pressed to the shadow mask to ensure close contact.

In any of the above embodiments of the device according to the invention, it is preferred, that the direction of gravity is perpendicular to the surface of the substrate and that the shadow mask is arranged on top of the substrate.

These and other features and advantages of the invention will be elucidated in conjunction with the accompanying drawings.
Figure 1 shows schematically in perspective view an embodiment of the device according to the invention.
Figures 2A - 2C show three steps of arranging a shadow mask on a substrate with the device according to figure 1.
Figure 3 shows two embodiments of a shadow mask.
Figure 4 shows a second embodiment of a device according to the invention.

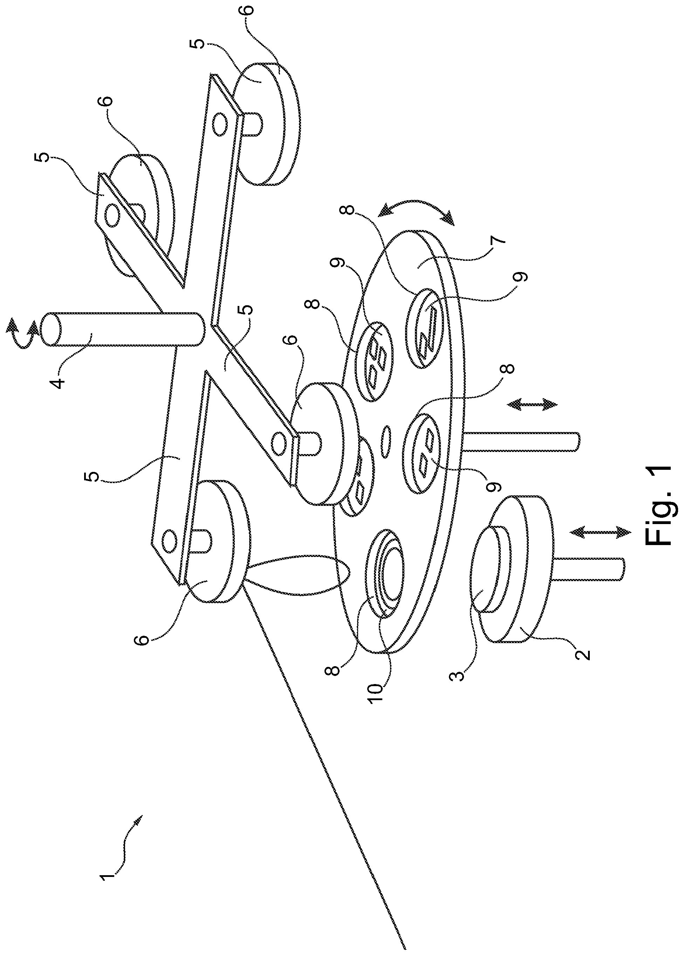

Figure 1 shows schematically an embodiment 1 of the invention. This device 1 comprises a substrate mount 2 and a substrate 3 mounted on the substrate mount 2. This substrate mount 2 is movable in vertical direction.

Above the substrate mount 2 a rotatable frame 4 with four arms 5 is arranged. On each free end of the arms 5 a target mount 6 is arranged. On each target mount a specific target material can be arranged.

In between the target mount 6 and the substrate mount 2, a rotatable disc 7 is arranged. The disc 7 has five openings 8, in which shadow masks 9 are arranged except for one opening 8.

From the opening 8, in which no shadow mask 9 is present, it is clear, that each opening is provided with a flange 10, which supports the shadow mask 9.

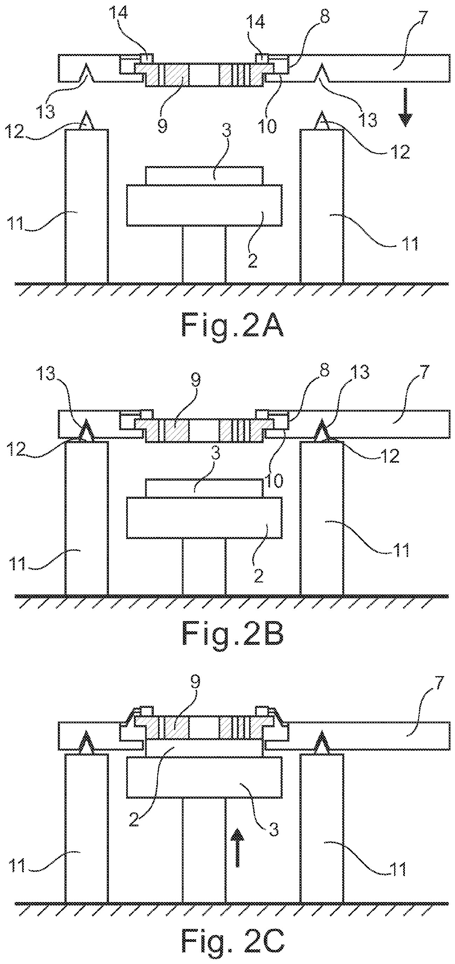

Figure 2A shows the device 1 according to figure 1 in cross sectional view. On each side of the substrate mount 2, posts 11 are arranged with positioning tips 12. These tips 12 are intended to interlock with notches 13 present in the rotatable disc 7. This ensures a correct alignment of the rotatable disc 7 relative to the substrate mount 2 and the substrate 3.

The shadow mask 9 itself is provided with a reduced diameter at the bottom, which is almost the same as the inner diameter of the flange 10. This ensures a proper alignment of the shadow mask 9 relative to rotatable disc 7.

On top of the shadow mask 9 a number of spring elements 14 are present, which urge the shadow mask 9 into the opening 8 of the disc 7.

In the next step, shown in figure 2B, the rotatable disc 7 is lowered, such that the tips 12 interlock with the notches 13. In this way it is ensured, that the disc 7 and also the shadow mask 9 is aligned properly relative to the substrate 3.

Then the substrate mount 2 with the substrate 3 is moved up, as shown in figure 2C. As result the substrate 3 is brought in abutment with the shadow mask 9, as is necessary for a sharp image of the mask in the coating deposited by the PLD technique.

By bringing the shadow mask 9 in close contact with the substrate, the shadow mask 9 is pushed somewhat up in the opening 8, such that the shadow mask 9 is located above the flange 10. The advantage is that when the shadow mask 9 and substrate 3 expand due to high temperatures, the shadow mask 9 is not restricted by the disc 7 and in particular the flange 10 of the opening 8.

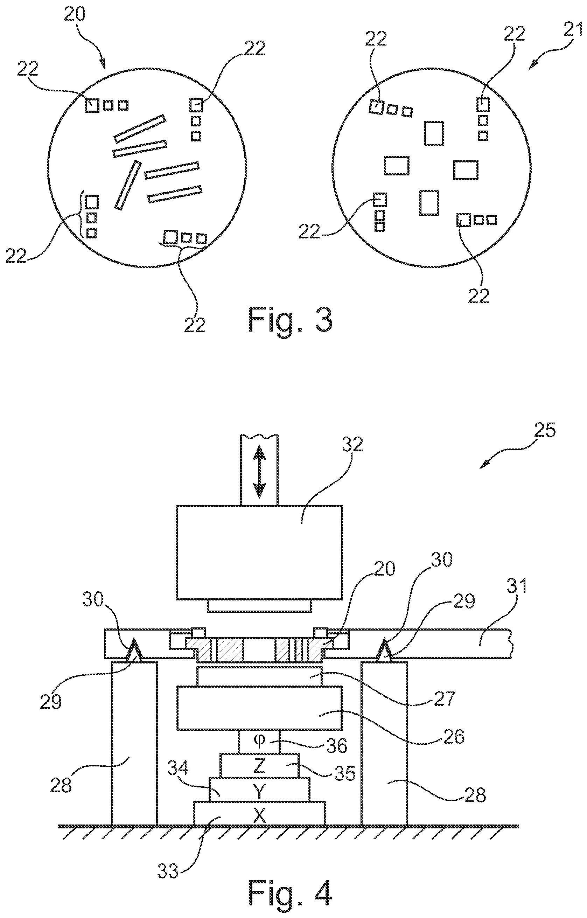

In figure 3 two embodiments of a shadow mask 20, 21 are shown. These shadow masks 20, 21 are typically applied after each other. To ensure that the shadow masks 20, 21 are aligned correctly, each shadow mask 20, 21 comprises alignment markers 22, which are arranged at a predetermined position on the shadow mask 20, 21. With these alignment markers it is possible to determine the exact orientation of a shadow mask and to align the substrate to the shadow mask.

In figure 4 a second embodiment 25 of a device according to the invention is shown. This embodiment 25 has a substrate mount 26 with a substrate 27 mounted on top. On each side of the substrate mount 26 posts 28 with positioning tips 29 are arranged. The positioning tips 29 interlock with notches 30 in the rotatable disc 31. This ensures a proper alignment of the disc 31 to the posts 28 and accordingly the substrate mount 26.

In order to ensure a proper alignment of the shadow mask 20 to the substrate 27, a microscope 32 is lowered to near the shadow mask 20. With the microscope 32 the alignment markers 22 can be observed and the substrate 27 below the shadow mask 20. The alignment markers of a previous mask will have left a mark on the substrate 27 and by aligning these marks with the alignment markers 22 it is ensured that the next shadow mask 20 is properly aligned.

The alignment can be performed by positioning the substrate mount 26 with the positioners 34, 35, 36, 37 which provide movement in all three dimensions as well as a rotation.

## Claims

1. Device (1) for pulsed laser deposition, which device (1) comprises:
- a substrate mount (2)with a substrate (3) mounted thereon;
- a target mount (6) with a target material mounted thereon and opposite of the substrate mount (2);
- a laser device for directing a laser beam on the target material; and
- a shadow mask (9) arranged over the substrate (3);
wherein the shadow mask (9) is arranged in a movable disc (7), which movable disc (7) is rotatable and movable in axial direction to and from the substrate mount (2)
**characterized in that** the movable disc (7) is movable in axial direction to bring the shadow mask (9) in abutment with the substrate (3) and wherein the device (1) further comprises spring means (14) for urging the at least one shadow mask (9) against the movable disc (7).

2. Device according to claim 1, wherein the movable disc comprises a number of shadow masks.

3. Device according to claim 1 or 2, wherein the movable disc comprises at least one opening for housing the shadow mask.

4. Device according to claim 3, wherein the opening comprises a flange for supporting the shadow mask.

5. Device according to any of the preceding claims, comprising a weight arranged on top of the at least one shadow mask for urging the mask against the movable disc.

6. Device according to any of the preceding claims, wherein the at least one shadow mask comprises primary alignment means for aligning the shadow mask relative to the movable disc.

7. Device according to any of the preceding claims, comprising secondary alignment means for aligning the movable disc to the substrate mount.

8. Device according to claim 7, wherein at least two alignment notches are arranged on opposite sides of the substrate mount for aligning cooperation with the movable disc.

9. Device according to any of the preceding claims, wherein the target mount is arranged on a rotatable arm comprising a number of target mounts.

10. Device according to any of the preceding claims, comprising vision means for observing the orientation of the at least one shadow mask relative to the substrate.

11. Device according to claim 10, wherein the vision means comprise a camera or a microscope.

12. Device according to claim 10 or 11, wherein the vision means are movable towards and away from the at least one shadow mask.

13. Device according to any of the claims 10 - 12 and claim 9, wherein the vision means are arranged on the rotatable arm.

14. Method for operating a device according to claim 9, the method comprising the steps of:
- arranging a first shadow mask over the substrate and lowering the movable disc, such that the shadow mask is in abutment with the substrate;
- radiating the target material with the laser beam, such that a coating of target material is arranged on the substrate in accordance with the first shadow mask;
- moving the movable disc up and rotating the disc, such that a second shadow mask is arranged over the substrate; and
- repeating the steps.

15. Method according to claim 14, wherein the rotatable arm is rotated such that a second target mount with a second target material is arranged opposite of the substrate.

16. Method according to claim 14 or 15, comprising the step of moving the substrate mount up after lowering the movable disc.

## Patentansprüche

1. Vorrichtung (1) zum gepulsten Laserstrahlverdampfen, wobei die Vorrichtung (1) umfasst:
- eine Substrathalterung (2) mit einem Substrat (3) darauf gehalten;
- eine Zielhalterung (6) mit einem Zielmaterial darauf gehalten und gegenüber der Substrathalterung (2);
- eine Laservorrichtung zum Richten eines Laserstrahls auf das Zielmaterial; und
- eine Lochmaske (9), die über dem Substrat (3) angeordnet ist;
wobei die Lochmaske (9) in einer bewegbaren Scheibe (7) angeordnet ist, wobei die bewegbare Scheibe (7) drehbar und in einer axialen Richtung zu und von der Substrathalterung (2) bewegbar ist,
**dadurch gekennzeichnet, dass** die bewegbare Scheibe (7) in axialer Richtung bewegbar ist, um die Lochmaske (9) zum Anliegen mit dem Substrat (3) zu bringen und wobei die Vorrichtung (1) weiter Federmittel (14) zum Drücken der mindestens einen Lochmaske (9) gegen die bewegbare Scheibe (7) umfasst.

2. Vorrichtung nach Anspruch 1, wobei die bewegbare Scheibe eine Anzahl von Lochmasken umfasst.

3. Vorrichtung nach Anspruch 1 oder 2, wobei die bewegbare Scheibe mindestens eine Öffnung zum Aufnehmen der Lochmaske umfasst.

4. Vorrichtung nach Anspruch 3, wobei die Öffnung einen Flansch zum Stützen der Lochmaske umfasst.

5. Vorrichtung nach einem der vorstehenden Ansprüche, umfassend ein auf der mindestens einen Lochmaske angeordnetes Gewicht zum Drücken der Maske gegen die bewegbare Scheibe.

6. Vorrichtung nach einem der vorstehenden Ansprüche, wobei die mindestens eine Lochmaske Primärausrichtungsmittel zum Ausrichten der Lochmaske bezüglich der bewegbaren Scheibe umfasst.

7. Vorrichtung nach einem der vorstehenden Ansprüche, umfassend Sekundärausrichtungsmittel zum Ausrichten der bewegbaren Scheibe an der Substrathalterung.

8. Vorrichtung nach Anspruch 7, wobei mindestens zwei Ausrichtungsaussparungen auf gegenüberliegenden Seiten der Substrathalterung zur Ausrichtungszusammenarbeit mit der bewegbaren Scheibe angeordnet sind.

9. Vorrichtung nach einem der vorstehenden Ansprüche, wobei die Zielhalterung auf einem drehbaren Arm, der eine Anzahl von Zielhalterungen umfasst, angeordnet ist.

10. Vorrichtung nach einem der vorstehenden Ansprüche, umfassend Sichtmittel zum Einhalten der Orientierung der mindestens einen Lochmaske bezüglich des Substrats.

11. Vorrichtung nach Anspruch 10, wobei die Sichtmittel eine Kamera oder ein Mikroskop umfassen.

12. Vorrichtung nach Anspruch 10 oder 11, wobei die Sichtmittel zu der mindestens einen Lochmaske hin und von dieser weg bewegbar sind.

13. Vorrichtung nach einem der Ansprüche 10-12 und Anspruch 9, wobei die Sichtmittel auf dem drehbaren Arm angeordnet sind.

14. Verfahren zum Betreiben einer Vorrichtung nach Anspruch 9, wobei das Verfahren die Schritte umfasst zum:
- Anordnen einer ersten Lochmaske über dem Substrat und Absenken der bewegbaren Scheibe, sodass die Lochmaske zum Anliegen mit dem Substrat kommt;
- Bestrahlen des Zielmaterials mit dem Laserstrahl, sodass eine Zielmaterialbeschichtung auf dem Substrat gemäß der ersten Lochmaske angeordnet ist;
- Bewegen der bewegbaren Scheibe nach oben und Drehen der Scheibe, sodass eine zweite Lochmaske über dem Substrat angeordnet ist; und
- Wiederholen der Schritte.

15. Verfahren nach Anspruch 14, wobei der drehbare Arm gedreht wird, sodass eine zweite Zielhalterung mit einem zweiten Zielmaterial gegenüber dem Substrat angeordnet ist.

16. Verfahren nach Anspruch 14 oder 15, umfassend den Schritt zum Bewegen der Substrathalterung nach oben nach Absenken der bewegbaren Scheibe.

## Revendications

1. Dispositif (1) de dépôt par laser à impulsion, lequel dispositif (1) comprend :
- un support de substrat (2) avec un substrat (3) monté dessus ;
- un support de cible (6) avec un matériau de cible monté dessus et opposé au support de substrat (2) ;
- un dispositif laser pour diriger un faisceau laser sur le matériau de cible ; et
- un masque perforé (9) agencé sur le substrat (3) ;
dans lequel le masque perforé (9) est agencé dans un disque mobile (7), lequel disque mobile (7) est rotatif et mobile dans une direction axiale vers et depuis le support de substrat (2)
**caractérisé en ce que** le disque mobile (7) est mobile dans une direction axiale pour amener le masque perforé (9) en butée avec le substrat (3) et dans lequel le dispositif (1) comprend en outre des moyens à ressort (14) pour pousser le au moins un masque perforé (9) contre le disque mobile (7).

2. Dispositif selon la revendication 1, dans lequel le disque mobile comprend un certain nombre de masques perforés.

3. Dispositif selon la revendication 1 ou 2, dans lequel le disque mobile comprend au moins une ouverture pour loger le masque perforé.

4. Dispositif selon la revendication 3, dans lequel l'ouverture comprend une bride pour supporter le masque perforé.

5. Dispositif selon l'une quelconque des revendications précédentes, comprenant un poids agencé au-dessus du au moins un masque perforé pour pousser le masque contre le disque mobile.

6. Dispositif selon l'une quelconque des revendications précédentes, dans lequel le au moins un masque perforé comprend des moyens d'alignement primaires pour aligner le masque perforé par rapport au disque mobile.

7. Dispositif selon l'une quelconque des revendications précédentes, comprenant des moyens d'alignement secondaires pour aligner le disque mobile sur le support de substrat.

8. Dispositif selon la revendication 7, dans lequel au moins deux encoches d'alignement sont agencées sur des côtés opposés du support de substrat pour aligner une coopération avec le disque mobile.

9. Dispositif selon l'une quelconque des revendications précédentes, dans lequel le support de cible est agencé sur un bras rotatif comprenant un certain nombre de supports de cible.

10. Dispositif selon l'une quelconque des revendications précédentes, comprenant des moyens de vision pour observer l'orientation du au moins un masque perforé par rapport au substrat.

11. Dispositif selon la revendication 10, dans lequel les moyens de vision comprennent une caméra ou un microscope.

12. Dispositif selon la revendication 10 ou 11, dans lequel les moyens de vision sont déplaçables vers le et à l'écart du au moins un masque perforé.

13. Dispositif selon l'une quelconque des revendications 10-12 et la revendication 9, dans lequel les moyens de vision sont agencés sur le bras rotatif.

14. Procédé pour faire fonctionner un dispositif selon la revendication 9, le procédé comprenant les étapes suivantes :
- l'agencement d'un premier masque perforé sur le substrat et l'abaissement du disque mobile, de sorte que le masque perforé est en butée avec le substrat ;
- l'irradiation du matériau de cible avec le faisceau laser, de sorte qu'un revêtement de matériau de cible est agencé sur le substrat conformément au premier masque perforé ;
- le déplacement du disque mobile vers le haut et la rotation du disque, de sorte qu'un second masque perforé est agencé sur le substrat ; et
- la répétition des étapes.

15. Procédé selon la revendication 14, dans lequel le bras rotatif est mis en rotation de sorte qu'un second support de cible avec un second matériau de cible est agencé à l'opposé du substrat.

16. Procédé selon la revendication 14 ou 15, comprenant l'étape de déplacement du support de substrat vers le haut après avoir abaissé le disque mobile.
